# EUROPEAN PATENT SPECIFICATION

(11) **EP 3 710 200 B1**
(45) Date of publication and mention of the grant of the patent: **02.12.2026**
(21) Application number: 18876326.2
(22) Date of filing: 30.10.2018
(51) Int. Cl.: B24B 57/02, B24B 37/005

(54) **CLOG DETECTION IN A MULTI-PORT FLUID DELIVERY SYSTEM**
VERSTOPFUNGSERKENNUNG IN EINEM FLÜSSIGKEITSABGABESYSTEM MIT MEHREREN ANSCHLÜSSEN
DÉTECTION D'OBSTRUCTION DANS UN SYSTÈME DE DISTRIBUTION DE FLUIDE À ORIFICES MULTIPLES

(30) Priority: 13.11.2017 US 201762585364 P; 14.02.2018 US 201862630654 P
(43) Date of publication of application: 23.09.2020
(73) Proprietor: Applied Materials, Inc., Santa Clara, CA 95054 (US)
(72) Inventor: NANGOY, Roy, C., Santa Clara, California 95051 (US); POLLARD, Chad, San Jose, California 95118 (US); D'AMBRA, Allen, L., Burlingame, California 94010 (US)
(74) Representative: Zimmermann & Partner Patentanwälte mbB
(86) International application number: PCT/US2018/058202
(87) International publication number: WO 2019/094227

(56) References cited:
- WO-A1-03/011523
- CN-A- 1 537 037
- KR-A- 20150 100 536
- KR-A- 20150 104 790
- US-A1- 2004 060 607
- US-A1- 2005 211 802
- US-A1- 2008 076 332
- US-A1- 2009 025 472

## Description

### BACKGROUND

### Field

Embodiments described herein generally relate to apparatus and methods used in semiconductor device manufacturing, and more particularly, to apparatus and methods used for the delivery of fluids during chemical mechanical planarization (CMP) of a substrate in an electronic device fabrication process.

### Description of the Related Art

Chemical mechanical polishing (CMP) is commonly used in the manufacture of high-density integrated circuits to planarize or polish a layer of material deposited on a substrate, by contacting the material layer to be planarized with a polishing pad mounted on a polishing platen, and moving one or both of the polishing pad and the substrate (and thus the material layer surface on the substrate) with respect to each other in the presence of a polishing fluid.

Polishing fluid delivery systems are commonly used in CMP processes to deliver the polishing fluid to the surface of the polishing pad and thus deliver the polishing fluid to an interface between the polishing pad and the material layer surface on the substrate. Typically, the polishing fluid comprises abrasive particles suspended in a suspension fluid and/or reactive agent (i.e. a slurry) where the abrasive particles provide at least a mechanical action against the material layer surface of the substrate to desirably remove material therefrom. Often, delivery lines in the fluid delivery systems become undesirably restricted, and in some cases fully obstructed, by condensed and dried slurry disposed therein, resulting in partial or full obstructions in the polishing fluid delivery lines, inconsistent polishing results, and frequent system maintenance requirements.

Accordingly, there is a need in the art for apparatus and methods to detect obstructions and restrictions in CMP fluid delivery systems.

Document US 2008/076332 A1 relates to a system that processes chemical mechanical planarization (CMP) slurries to reduce or eliminate particles in the slurries, which can scratch integrated circuit wafers without substantially altering a percentage of solids in the CMP slurry by weight. In particular, the system breaks up particles of a CMP slurry using an intensifier pump system and a fluid processing device. The techniques have proven much more effective than conventional filtering techniques in reducing or eliminating scratches to integrated circuit wafers when a processed CMP slurry is used in a CMP process.

Document WO 03/011523 A1 relates to a method and system for delivering a polishing fluid to a chemical mechanical polishing surface. In one embodiment, the system includes an arm having a delivery portion disposed at least partially over the polishing surface. A first nozzle and a second nozzle are disposed on the delivery portion of the arm. The first nozzle is adapted to flow the polishing fluid at a first rate while the second nozzle is adapted to flow the polishing fluid at a second rate that is different than the first rate.

### SUMMARY

Embodiments of the present disclosure provide for apparatus for detecting the presence of obstruction(s) and restriction(s) in a fluid delivery system used in chemical mechanical polishing (CMP) apparatus and processes and methods of detecting obstruction(s) and restriction(s) in such a fluid delivery system during chemical mechanical polishing (CMP) processes.

The invention according to claim 1 provides a fluid delivery apparatus for delivery of fluids during chemical mechanical planarization of a substrate includes a unitary manifold body having an inlet port, a plurality of outlet ports, a pressure measuring port, a first fluid delivery conduit, a plurality of second fluid delivery conduits and a plurality of pressure measuring conduits formed therein. The apparatus comprises a plurality of outlet fittings respectively disposed in each of the plurality of outlet ports, wherein each of the plurality of outlet fittings respectively form a face to face seal with each of the plurality of outlet ports and each of the plurality of outlet fittings are configured to fluidly connect the plurality of second fluid delivery conduits to a corresponding delivery line of a plurality of delivery lines. The inlet port is in fluid communication with the plurality of outlet ports through the first fluid delivery conduit and the plurality of second delivery conduits. The plurality of second fluid delivery conduits connect the first fluid delivery conduit to the plurality of outlet ports and the plurality of pressure measuring conduits connect the pressure measuring port to corresponding ones of the plurality of second fluid delivery conduits so that the pressure measuring port is in direct fluid communication therewith.

The invention according to claim 13 provides a method of detecting obstruction or restriction in a multi-dispense nozzle fluid delivery system comprises flowing a polishing fluid to an inlet port of a fluid delivery apparatus for delivery of fluids during chemical mechanical planarization of a substrate, the apparatus comprising a unitary manifold body having an inlet port, a plurality of outlet ports, a pressure measuring port, a first fluid delivery conduit, a plurality of second fluid delivery conduits and a plurality of pressure measuring conduits formed therein. The apparatus comprises a plurality of outlet fittings respectively disposed in each of the plurality of outlet ports, wherein each of the plurality of outlet fittings respectively form a face to face seal with each of the plurality of outlet ports and each of the plurality of outlet fittings are configured to fluidly connect the plurality of second fluid delivery conduits to a corresponding delivery line of a plurality of delivery lines. The inlet port is in fluid communication with the plurality of outlet ports through the first fluid delivery conduit and the plurality of second delivery conduits. The plurality of second fluid delivery conduits connect the first fluid delivery conduit to the plurality of outlet ports and the plurality of pressure measuring conduits connect the pressure measuring port to corresponding ones of the plurality of second fluid delivery conduits so that the pressure measuring port is in direct fluid communication therewith. The apparatus further comprises a pressure measuring device fluidly coupled to the pressure measuring port. The method comprises measuring by use of the pressure measuring device, a pressure of the polishing fluid disposed in the plurality of second fluid delivery conduits, dispensing the polishing fluid onto a surface of a polishing pad through a plurality of dispense nozzles, wherein each of the plurality of dispense nozzles are fluidly coupled to respective delivery lines of the plurality of delivery lines and urging a substrate against the polishing pad in the presence of the polishing fluid.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings.
Figure 1A is a schematic sectional view of a polishing system using a multi-dispense nozzle fluid delivery system, according to embodiments described herein.
Figure 1B is a schematic view of a dispense nozzle used in the fluid delivery system shown in Figure 1A, according to embodiments described herein.
Figure 2A is a schematic isometric view of the flow splitter manifold 130 shown in Figure 1A.
Figure 2B is a cross-sectional view of the manifold body of the flow splitter manifold shown in Figure 1A and 2A taken along line 2B-2B of Figure 2A.
Figure 2C is a cross-sectional view of the manifold body shown in Figures 1A and 2A-2B taken along line 2C-2C of Figure 2A.
Figure 3 is a flow diagram setting forth a method of detecting obstruction(s) and restriction(s) in a multi-dispense nozzle fluid delivery system, according to embodiments described herein.

To facilitate understanding, identical reference numerals have been used, where possible, to designate identical elements that are common to the figures.

### DETAILED DESCRIPTION

Embodiments of the present disclosure provide for apparatus for detecting obstruction(s) in a fluid delivery system during chemical mechanical polishing (CMP) processes and methods of detecting obstruction(s) and restrictions in such a fluid delivery system during CMP processes. During a conventional CMP process, polishing fluids are dispensed to a location near the center of the polishing pad through a fluid dispense arm positioned thereover. The dispensed polishing fluid is distributed radially outwardly from the dispensed location by the centrifugal force imparted thereto by the rotating polishing pad and along grooves and/or channels formed in the polishing pad. Multi-port dispense arms and/or multi-dispense nozzle distribution systems enable reduced polishing fluid consumption during CMP, when compared to a conventional CMP process, by spacing a plurality of dispense openings and/or dispense nozzles across a radius of the polishing pad and uniformly dispensing the polishing fluid therefrom. In a conventional fluid delivery system, the flowrate of fluid flowing to a single dispense opening/nozzle is typically monitored using a flowmeter and/or flow controller positioned in and/or on a delivery line leading thereto. Obstruction(s) and restrictions in a conventional fluid delivery system are detected by disruptions in the rate of fluid flow to the single monitored dispense opening/nozzle. In a multi-dispense nozzle distribution system measuring and/or monitoring the flowrate in individual delivery lines is costly, impracticable, and in some circumstances disrupts the flow of the polishing fluid flowing therethrough. Therefore, embodiments herein provide a flow splitter manifold, and a pressure measuring device coupled thereto, that enables measuring and monitoring of the pressure of the polishing fluid in the flow splitter manifold. Monitoring the fluid pressure in the flow splitter manifold enables the detection of the presence of an obstruction or restriction in one or more of the delivery lines and dispense nozzles that inhibit or prevent the flow of polishing fluid therethrough or therefrom.

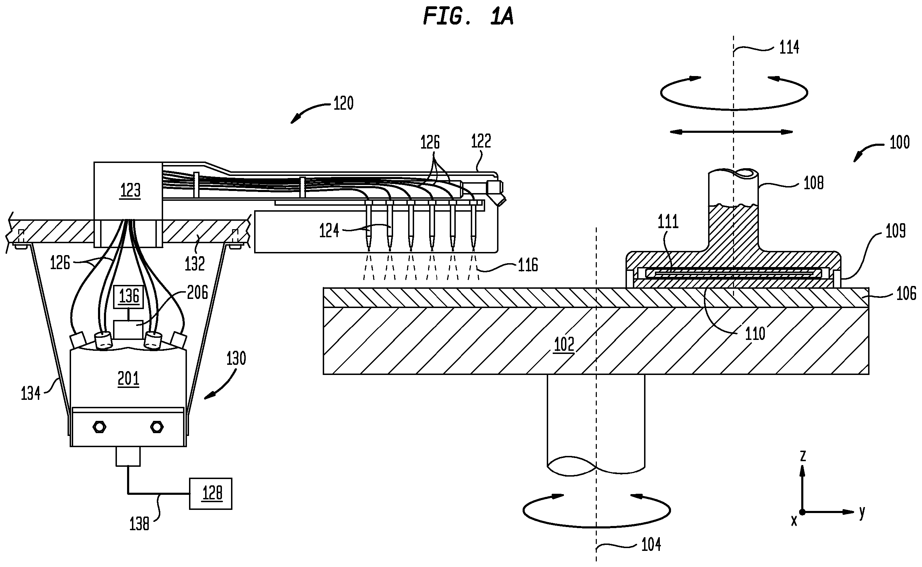

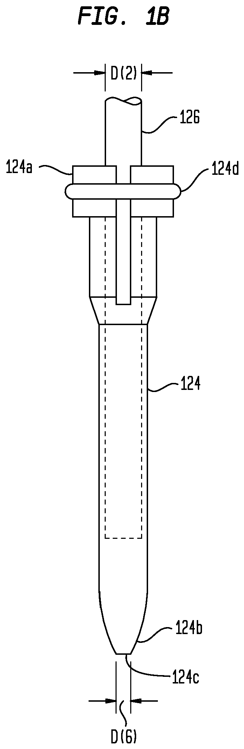

Figure 1 is a schematic sectional view of an example polishing system using a multi-dispense nozzle fluid delivery system according to embodiments described herein. The polishing system 100 typically includes a polishing platen 102 rotatably disposed about a platen axis 104, a polishing pad 106 mounted on the upper surface of the polishing platen 102, a substrate carrier 108 rotatably disposed about a carrier axis 114 and having a substrate holding surface facing the polishing platen 102, a polishing fluid delivery system, such as the multiport polishing fluid delivery system 120 described herein, disposed on a base plate 132, and a polishing pad conditioning apparatus (not shown). Herein, the substrate carrier 108 includes a flexible diaphragm 111 configured to impose different pressures against different regions of a substrate 110 on the substrate holding surface thereof while urging the to be polished surface of the substrate 110 against the polishing surface of the polishing pad 106, and a carrier ring 109 surrounding the substrate 110.

During polishing, a downforce on the carrier ring 109 urges the carrier ring 109 against the polishing pad 106 which prevents the substrate 110 from slipping from the substrate carrier 108 during the polishing process and deforms the pad to reduce or eliminate polishing edge effects on the substrate edge. The substrate carrier 108 rotates about the carrier axis 114 while the flexible diaphragm 111 urges the to be polished surface of the substrate 110 against the polishing surface of the polishing pad 106. The platen 102 rotates about the platen axis 104 in an opposite rotational direction from the rotation direction of the substrate carrier 108. Concurrently, the substrate carrier 108 sweeps back and forth from an inner diameter of the platen 102 to an outer diameter of the platen 102 to, in part, reduce uneven wear of the polishing pad 106.

During polishing, one or more polishing fluids 116 are introduced to the polishing pad 106 using fluid delivery system 120. The fluid delivery system 120 herein is a multi-dispense nozzle fluid delivery system and includes a delivery arm 122 coupled to an actuator 123 that positions the delivery arm 122 above the polishing pad 106 by swinging the delivery arm 122 thereover and/or lowering the delivery arm 122 theretowards. The fluid delivery system 120 further includes a plurality of dispense nozzles 124 disposed on and/or in the delivery arm 122, and a plurality of delivery lines 126 fluidly coupling the dispense nozzles to a flow splitter manifold 130. Typically, the plurality of dispense nozzles 124 includes between about 2 and 20 dispense nozzles, such as between 2 and 15 dispense nozzles, for example between about 2 and 10 dispense nozzles. Herein, the flow splitter manifold 130 is fluidly coupled to a polishing fluid supply 128 and is also secured to a base plate 132 by a support bracket 134. In embodiments herein, the flow splitter manifold 130 is disposed below a horizontal plane of the delivery arm 122 so that the dispense nozzles 124 are disposed above the flow splitter manifold 130 to prevent syphoning of polishing fluid therefrom and to ensure that polishing fluid does not undesirably drain from the flow splitter manifold 130 during periods of non-use. Draining of polishing fluid 116 from the flow splitter manifold 130 undesirably contributes to agglomeration of abrasive particles commonly found in polishing fluids by the drying thereof, the coagulation of the polishing fluid by exposure thereof to the oxygen containing atmosphere, and/or condensation of the polishing fluid on the inner surfaces of the fluid delivery system 120.

Figure 1B is a close up schematic view of one of the plurality of dispense nozzles 124 shown in Figure 1A. The dispense nozzle 124 is configured for quick change out thereof during routine maintenance and/or after an obstruction or restriction is detected therein. Herein, the dispense nozzle 124 comprises an elongated body having a first end 124a for receiving one of the plurality of delivery lines 126 and a second end 124b for dispensing the polishing fluid 116 onto the polishing pad 106. The dispense nozzle 124 is secured to an end of the delivery line 126 by an O-ring 124d disposed about the first end 124a thereof and interferingly received within a corresponding opening in the delivery arm 122. Herein, the plurality of dispense nozzles 124 and the plurality of delivery lines 126 are formed of one or more fluorine-containing polymers (fluorpolymers), such as perfluoroalkoxy (PFA), fluorinated ethylene propylene (FEP), or polytetrafluoroethylene (PTFE) commercially available as TEFLON^{®} from DuPont Co., or combinations thereof.

During CMP processes, the polishing fluid 116 flows through an opening 124c formed in the second end 124b of the dispense nozzle 124. The opening 124c has a diameter D(6) that is less than the diameter D(2) of the delivery line 126 creating a backpressure on the polishing fluid disposed in the delivery line 126. Obstructing and restricting of the fluid flow within the dispense nozzle 124 and/or delivery line 126 creates sufficient backpressure in the delivery line 126, and in fluid conduits in communication therewith, to enable detection of a change of fluid pressure in the flow splitter manifold 130 by a pressure measuring device 206 coupled thereto. In some embodiments, a controller 136 is used to monitor the pressure measured by the pressure measuring device 206. In some embodiments, the controller 136 is configured to sound an alarm and/or to stop the polishing process if the measured pressure in the flow splitter manifold 130 is outside of a determined range of the desired fluid pressure.

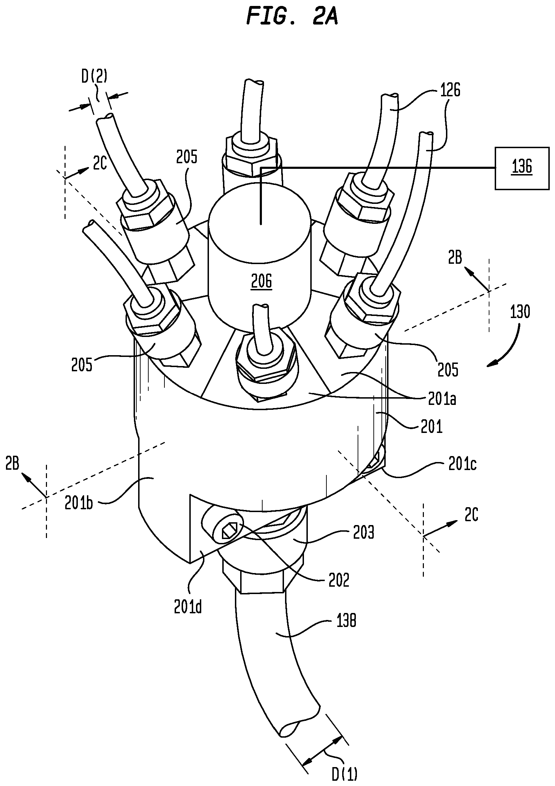

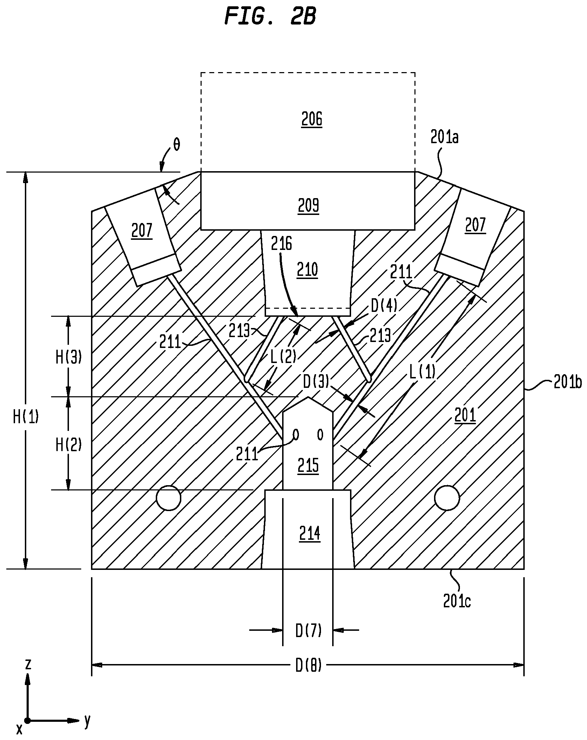

Figure 2A is a schematic isometric view of the flow splitter manifold 130 shown in Figure 1A. Herein, the flow splitter manifold 130 includes a manifold body 201 having a top surface 201a, one or more side surfaces 201b, a bottom surface 201c, and one or more recessed surfaces 201d, where the one or more recessed surfaces 201d are used to secure the manifold body 201 to the support bracket 134 shown in Figure 1 with one or more fasteners 202. The flow splitter manifold 130 further includes plurality of outlet fittings, such as a plurality of second fittings 205, each disposed in a respective second port 207 (shown in Figure 2B) formed in the top surface 201a of the manifold body 201. Each of the plurality of second fittings 205 fluidly couple a respective delivery line 126 to a delivery conduit, such as a second conduit 211 (shown in Figure 2B) formed in the manifold body 201. Typically, each of the plurality of delivery lines 126 have an inner diameter D(2) between about 1 mm and about 10 mm, such as between about 1 mm and about 5 mm, for example about 3 mm and the inlet line has an inner diameter D(1) between about 5 mm and about 20 mm, such as between about 5 mm and about 15 mm, for example about 10 mm.

The pressure measuring device 206, such as a pressure gauge, is herein coupled to the manifold body 201 using a third fitting (not shown). The fittings described herein are appropriately sized to fluidly couple the respective inlet line, delivery line, or pressure measuring device to fluid conduits disposed in and/or through the manifold body 201 of the flow splitter manifold 130. Typically, the fittings described herein are formed of one or more fluorine-containing polymers (fluorpolymers), such as perfluoroalkoxy (PFA), fluorinated ethylene propylene (FEP), or polytetrafluoroethylene (PTFE) commercially available as TEFLON^{®} from DuPont, or combinations thereof. In some embodiments, the fittings described herein are selected from the LQ^{®} High Purity Fluoropolymer series available from SMC Corporation of America of Noblesville, IN. In some embodiments, the fittings described herein are configured to form a face to face seal with the respective fitting port to reduce and/or eliminate dead space therebetween. In some embodiments, the manifold body 201 comprises a unitary body formed of a fluorine-containing polymer.

During CMP processes, the pressure measuring device 206 and the controller 136 in communication therewith monitor the pressure of the polishing fluid 116 disposed in a plurality of fluid delivery conduits, such as a plurality of second conduits 211, through a plurality of pressure measuring conduits, such as a plurality of third conduits 213. Conduits formed in and/or through the manifold body 201 are shown in Figure 2B.

Figure 2B is a cross-sectional view of the manifold body 201 of the flow splitter manifold 130 shown in Figure 2A taken along line 2B-2B. Typically, the manifold body 201 is formed of a polishing fluid and slurry chemical resistant polymer, such as one or more fluorine-containing polymers (fluoropolymer), such as perfluoroalkoxy (PFA), fluorinated ethylene propylene (FEP), polytetrafluoroethylene (PTFE) commercially available as TEFLON^{®} from DuPont, or combinations thereof. Herein, the manifold body 201 is generally right cylindrically shaped and has a height H(1) between about 50 mm and about 100 mm and a diameter D(8) between 20 mm and about 80 mm. In other embodiments the manifold body 201 comprises other suitable shapes.

Herein, the manifold body 201 includes a plurality of delivery conduits extending in and/or through the material thereof. The plurality of delivery conduits includes at least a first conduit 215 and a plurality of second conduits 211. Herein, each of the plurality of second conduits 211 are disposed through the manifold body 201 and are fluidly coupled to a first conduit 215. The first conduit 215 has a height H(2) of between about 5 mm and about 20 mm, such as between 10 mm and about 15 mm and diameter D(7) of between about 5mm and about 20 mm, such as between about 5 mm and about 15 mm, for example about 10 mm. The first conduit 215 is fluidly coupled to the inlet line 138 (shown in Figure 2A) using an inlet fitting, such as a first fitting 203 (shown in Figure 2A) that is disposed in a first port 214 formed in the bottom surface 201c of the manifold body 201. Each of the plurality of second conduits 211 are fluidly coupled to a respective delivery line 126 (shown in Figure 2A) using a respective second fitting 205 (shown in Figure 2A) disposed in one of a plurality of second ports 207 formed in the top surface 201a of the manifold body 201. Herein, each of the plurality of second conduits 211 have a length L(1) of between about 5 mm and about 50 mm, such as between about 20 mm and about 50 mm, such as between about 30 mm and about 40 mm and diameter D(3) between about 0.5 mm and about 5 mm, such as between about 0.5 mm and about 2.5 mm, for example about 1 mm. Herein, the diameter D(7) of the first conduit 215 is more than the inner diameter D(2) of the to be coupled inlet line 138. In other embodiments, the diameter D(7) of the first conduit 215 is about the same or less than the inner diameter D(7) of the to be coupled inlet line 138.

The manifold body 201 further includes one or more pressure measuring conduits, such as the plurality of third conduits 213, extending in the material thereof. Herein, each of the plurality of third conduits 213 intersect a respective one of the second conduits 211, and are fluidly coupled thereto, at a location between the first conduit 215 and the respective second port 207. Typically, a length L(2) of each of the third conduits 213 is between about 1 mm and about 30 mm, such as between about 1 mm and about 20 mm, such as between about 1 mm and about 10mm and a diameter D(4) of each of the third conduits 213 is substantially the same as the diameter D(3) of the respective second conduit 211 in fluid communication therewith. In other embodiments the diameter D(4) of each of the third conduits 213 is less than or more than the diameter D(3) of a respective second conduit 211 and is between about 0.5 mm and about 5 mm, such as between about 0.5 mm and about 2.5 mm, for example about 1mm.

Herein the plurality of third conduits 213 are in fluid communication with the third port 210 and the pressure measuring device 206 (shown in Figure 2A) coupled thereto and are fluidly coupled to the pressure measuring device 206 by an appropriately sized third fitting (not shown). In some embodiments, the third port 210 and the third fitting disposed therein define a fluid reservoir 216. Herein, a material forming the manifold body 201 in a region between the first conduit 215 and the third port 210 has a thickness H(3) between about 0.5 mm and about 20 mm, such as between about 0.5 mm and about 5 mm, or for example a thickness necessary to ensure that the first conduit 215 is not in direct fluid communication with the third port 210 or the fluid reservoir 216 thereof. Fluidly coupling the pressure measuring device 206 and/or the fluid reservoir 216 to each of the plurality of second conduits 211, in contrast to a system where the pressure measuring device 206 and/or the fluid reservoir 216 is in direct fluid communication with the first conduit 215, dampens undesirable fluctuation of pressure measurements associated with inherent vibrations of the polishing system 100 during CMP processing.

In some embodiments, each of a plurality of pressure measuring devices are fluidly coupled to a respective second conduit 211 either directly or through a pressure measuring conduit disposed therebetween. In other embodiments, the third port 210 is connected to the first conduit 215 by one or more direct conduits disposed therebetween. In other embodiments, the third port 210 is in direct fluid communication with the first conduit 215. Typically, the ports 214, 207, 210 described herein are sized and/or threaded to receive the respective fittings described herein. In some embodiments, the manifold body further comprises a cavity 209 formed in the top surface 201a for receiving at least a portion of the pressure measuring device 206 which is coupled directly to the third fitting (not shown).

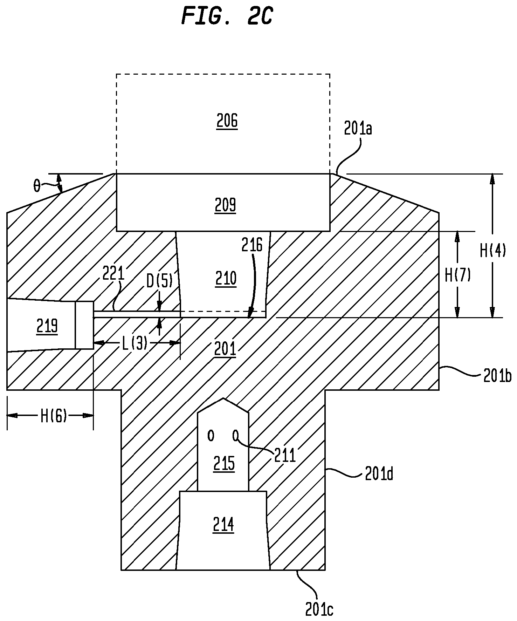

Figure 2C is a cross-sectional view of the manifold body 201 shown in Figures 2A-2B taken along line 2C-2C which is orthogonal to line 2B-2B. Herein, the manifold body 201 further includes a purge conduit, such as the fourth conduit 221, fluidly coupling the third port 210 and/or the fluid reservoir 216 to a fourth port 219 formed in a side surface 201b of the manifold body 201. In some embodiments, a fitting (not shown) disposed in the fourth port 219 fluidly couples the fourth conduit 221 to a bleed line (not shown) which enables air and/or other fluids trapped in the conduits and/or ports of the manifold body 201, such as air trapped in the fluid reservoir 216, to be purged therefrom. In some embodiments, air and/or other fluids are purged from the conduits and/or ports of the manifold body 201 by opening a valve (not shown) disposed on the bleed line while simultaneously flowing the polishing fluid 116 into the manifold body 201. Once the air and/or other fluids are purged from the manifold body 201 the valve is closed and normal operation of the fluid delivery system 120 may resume. In some embodiments, the valve is coupled to a controller and the manifold body 201 is routinely purged after extended periods of non-use to remove gases accumulated therein. Herein, the fourth conduit 221 has a length L(3) of between about 5 mm and about 50 mm and a diameter D(5) between about 0.5 mm and about 5 mm, such as between about 0.5 mm and about 2.5 mm, for example about 1 mm. Desirably, the valve is located proximate to the manifold body 201 to reduce any undesirable dampening effect on pressure fluctuations in the fluid reservoir 216 associated with the volume of fluid disposed in the bleed line coupled thereto.

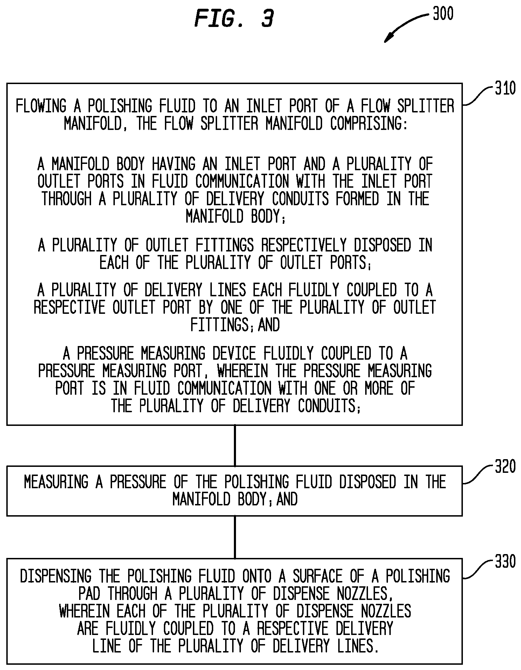

Figure 3 is a flow diagram illustrating a method of detecting obstruction(s) and restriction(s) in a multi-dispense nozzle fluid delivery system, according to embodiments described herein. The method 300 includes flowing a polishing fluid to an inlet port of a flow splitter manifold at activity 310. Herein, the flow splitter manifold comprises a manifold body having an inlet port and a plurality of outlet ports. Each of the plurality of outlet ports are in fluid communication with the inlet port through a plurality of delivery conduits formed in the manifold body. Herein, the flow splitter manifold further comprises a plurality of outlet fittings respectively disposed in each of the plurality of outlet ports, a plurality of delivery lines each fluidly coupled to a respective outlet port by one of the plurality of outlet fittings, and a pressure measuring device fluidly coupled to a pressure measuring port, wherein the pressure measuring port is in fluid communication with the plurality of delivery conduits. Typically, the polishing fluid comprises a polishing slurry flowed to the flow splitter manifold at a flowrate between about 50 ml/min and 1000 ml/min, such as between about 50 ml/min and 500 ml/min.

The method 300 further includes measuring the pressure of the polishing fluid disposed in the manifold body using the pressure measuring device at activity 320 and flowing the polishing fluid to a surface of a polishing pad through a plurality of dispense nozzles at activity 330, wherein each of the plurality of dispense nozzles are fluidly coupled to a respective delivery line of the plurality of delivery lines. In some embodiments, the method further includes monitoring the measured pressure using a controller coupled to and in communication with the pressure measuring device 206.

In some embodiments, the controller is configured to sound an alarm and/or to stop the polishing process if the measured pressure is outside of a determined range of the desired fluid pressure. For example, in one embodiment a fluid delivery system comprising six unobstructed dispense nozzles and delivering a combined flowrate of about 300 ml/min of polishing fluid to a polishing pad has a desired fluid pressure, measured in the flow splitter manifold as described in Figures 2A-2C, between about 2,67 kPa (20 Torr) (above atmospheric pressure) and about 5,33 kPa (40 Torr) (above atmospheric pressure), such as about 4.0 kPa (30 Torr) (above atmospheric pressure). When polishing fluid flow to and/or through one of the six dispense nozzles is obstructed the pressure in the flow splitter manifold increases to between about 5,33 kPa (40 Torr) (above atmospheric pressure) and about 8,0 kPa (60 Torr) (above atmospheric pressure) or between about 1.5 times and about 2 times the desired fluid pressure. When polishing fluid flow to and/or through two of the six dispense nozzles is obstructed the pressure in the flow splitter manifold 130 increases to between about 8,0 kPa (60 Torr) (above atmospheric pressure) and about 10,67 kPa (80 Torr) (above atmospheric pressure) or between about 2 times and about 3 times the desired fluid pressure. When the polishing fluid flow to and/or through more than two of the six dispense nozzles is obstructed and/or restricted the pressure increases to more than between about 10,67 kPa (80 Torr) (above atmospheric pressure) and about 13,33 kPa (100 Torr) (above atmospheric pressure), or more than between about 2 times and about 5 times the desired fluid pressure.

In one embodiment, the controller is configured to sound an alarm and/or to stop the polishing process when the measured pressure indicates that the polishing fluid flowrate to and/or through two or more dispense nozzles are obstructed and/or restricted. In another embodiment, the controller is configured to sound an alarm and/or to stop the polishing process if the measure pressure indicates that the polishing fluid flowrate to and/or through more than two dispense nozzles is obstructed and/or restricted.

In some embodiments, the method 300 further includes determining the delivery line and/or nozzle that has an obstruction or restriction disposed therein. In embodiments where a single pressure measuring device is used to monitor a plurality of dispense nozzles and the delivery lines coupled thereto a user must determine which dispense nozzle(s) and/or delivery line(s) are obstructed and/or restricted. In some embodiments, the location of the obstruction and/or restriction is determined by flowing fluid through the fluid delivery system and visually observing the fluid flow from each of the plurality of dispense nozzles. Typically, once the location of a restriction or obstruction is determined, the restricted or obstructed dispense nozzle(s) and/or delivery line(s) are replaced. In some embodiments the delivery arm, including the plurality of dispense nozzles and the delivery lines coupled thereto, is replaced with a new or refurbished arm in order to reduce equipment downtime related to troubleshooting the location of the restriction or obstruction. In some of those embodiments, the removed delivery arm is later refurbished by replacing and/or cleaning the plurality of dispense nozzles and or the delivery lines coupled thereto as a preventative maintenance procedure.

The methods and apparatus provided herein enable detection of one or more obstructions or restrictions in the delivery lines and/or dispense nozzles of a multi-nozzle fluid dispense system with sufficient sensitivity to avoid false alarms triggered by unavoidable and inherent vibrations of the polishing system during CMP processing.

## Claims

1. A fluid delivery apparatus for delivery of fluids during chemical mechanical planarization of a substrate, comprising:
a unitary manifold body (201) having an inlet port (214), a plurality of outlet ports (207), a pressure measuring port (210), a first fluid delivery conduit (215), a plurality of second fluid delivery conduits (211), and a plurality of pressure measuring conduits (213) formed therein; and
a plurality of outlet fittings (205) respectively disposed in each of the plurality of outlet ports (207), wherein each of the plurality of outlet fittings (205) respectively forms a face to face seal with each of the plurality of outlet ports (207), and
each of the plurality of outlet fittings (205) is configured to fluidly connect the plurality of second fluid delivery conduits (211) to a corresponding delivery line (126) of a plurality of delivery lines;
the inlet port (214) is in fluid communication with the plurality of outlet ports (207) through the first fluid delivery conduit (215) and the plurality of second fluid delivery conduits (211), the plurality of second fluid delivery conduits (211) connect the first fluid delivery conduit (215) to the plurality of outlet ports (207), and
the plurality of pressure measuring conduits (213) connect the pressure measuring port (210) to corresponding ones of the plurality of second fluid delivery conduits (211).

2. The fluid delivery apparatus of claim 1, comprising from about 2 to about 20 second fluid delivery conduits (211).

3. The fluid delivery apparatus of claim 1, wherein the unitary manifold body (201) is formed of a fluoropolymer.

4. The fluid delivery apparatus of claim 1, further comprising a pressure measuring device (206) fluidly coupled to the pressure measuring port (210).

5. The fluid delivery apparatus of claim 4, wherein the plurality of pressure measuring conduits (213) are in direct fluid communication with a fluid reservoir (216) disposed between the pressure measuring device (206) and the plurality of pressure measuring conduits (213).

6. The fluid delivery apparatus of claim 5, further comprising a fitting disposed in a fourth port (219) formed in a side surface (201 b) of the unitary manifold body (201), wherein a purge conduit (221) fluidly couples the fluid reservoir (216) to the fourth port (219), and the fitting is configured to fluidly connect the purge conduit (221) to a bleed line.

7. The fluid delivery apparatus of claim 1, wherein each of the plurality of second fluid delivery conduits (211) has a diameter between about 0.5 mm and about 5 mm.

8. The fluid delivery apparatus of claim 1, wherein the each of the plurality of outlet fittings (205) is configured to fluidly couple the respective second fluid delivery conduit (211) to the delivery line (126) having a larger diameter than the respective second fluid delivery conduit (211).

9. The fluid delivery apparatus of claim 8, further comprising a plurality of delivery lines (126) respectively fluidly coupled to each of the plurality of second fluid delivery conduits (211).

10. The fluid delivery apparatus of claim 9, further comprising a plurality of dispense nozzles (124) respectively coupled to each of the plurality of delivery lines (126).

11. The fluid delivery apparatus of claim 1, wherein each of the plurality of pressure measuring conduits (213) intersect a respective second fluid delivery conduit (211) between the first fluid delivery conduit (215) and a respective outlet port (207).

12. The fluid delivery apparatus of claim 11, wherein each of the plurality of pressure measuring conduits (211) has a diameter between about 0.5 mm and about 5 mm.

13. A method of detecting obstruction or restriction in a multi-dispense nozzle fluid delivery system, comprising:
flowing a polishing fluid to an inlet port of a fluid delivery apparatus according to one or more of the claims 1-11, and
a pressure measuring device fluidly coupled to the pressure measuring port;
measuring, by use of the pressure measuring device, a pressure of the polishing fluid disposed in the plurality of second fluid delivery conduits (211); and
dispensing the polishing fluid onto a surface of a polishing pad through a plurality of dispense nozzles (124), wherein each of the plurality of dispense nozzles (124) are fluidly coupled to respective delivery lines (126) of the plurality of delivery lines (126).

14. The method of claim 13, wherein the manifold body (201) is fixedly mounted to a polishing system and is disposed below a horizontal plane of a delivery arm having the plurality of dispense nozzles (124) disposed therein.

15. The method of claim 13, further comprising:
monitoring, by use of a system controller, the measured pressure of the polishing fluid disposed in the second fluid delivery conduits (211);
determining a change in the measured pressure; and
initiating a change in a polishing process and/or alerting a user based on the determined change in the measured pressure.

16. The method of claim 15, wherein the change in the measured pressure corresponds to an obstruction in one or more of the fluid delivery lines, one or more of the plurality of dispense nozzles (124), or both.

## Patentansprüche

1. Fluidabgabevorrichtung zur Abgabe von Fluiden während eines chemischmechanischen Planarisierens eines Substrats, umfassend:
einen einteiligen Verteilerkörper (201) mit einem Einlassanschluss (214), einer Vielzahl von Auslassanschlüssen (207), einem Druckmessanschluss (210), einer ersten Fluidabgabeleitung (215), einer Vielzahl von zweiten Fluidabgabeleitungen (211) und einer Vielzahl Druckmessleitungen (213), die darin ausgebildet sind; und
eine Vielzahl von Auslassfittings (205), die jeweils in jedem der Vielzahl von Auslassanschlüssen (207) angeordnet sind, wobei jedes der Vielzahl von Auslassfittings (205) jeweils eine Fläche-an-Fläche-Dichtung mit jedem der Vielzahl von Auslassanschlüssen (207) bildet, und
jedes der Vielzahl von Auslassfittings (205) dazu eingerichtet ist, die Vielzahl von zweiten Fluidabgabeleitungen (211) fluidisch mit einer entsprechenden Abgabeleitung (126) einer Vielzahl von Abgabeleitungen zu verbinden;
wobei der Einlassanschluss (214) über die erste Fluidabgabeleitung (215) und die Vielzahl von zweiten Fluidabgabeleitungen (211) in Fluidverbindung mit der Vielzahl von Auslassanschlüssen (207) steht, die Vielzahl von zweiten Fluidabgabeleitungen (211) die erste Fluidabgabeleitung (215) mit der Vielzahl von Auslassanschlüssen (207) verbindet,
und die Vielzahl von Druckmessleitungen (213) den Druckmessanschluss (210) mit entsprechenden der Vielzahl von zweiten Fluidabgabeleitungen (211) verbindet.

2. Fluidabgabevorrichtung nach Anspruch 1, umfassend etwa 2 bis etwa 20 zweite Fluidabgabeleitungen (211).

3. Fluidabgabevorrichtung nach Anspruch 1, wobei der einteilige Verteilerkörper (201) aus einem Fluorpolymer gebildet ist.

4. Fluidabgabevorrichtung nach Anspruch 1, ferner umfassend eine Druckmessvorrichtung (206), die mit dem Druckmessanschluss (210) fluidisch gekoppelt ist.

5. Fluidabgabevorrichtung nach Anspruch 4, wobei die Vielzahl von Druckmessleitungen (213) in direkter Fluidverbindung mit einem Fluidreservoir (216) steht, das zwischen der Druckmessvorrichtung (206) und der Vielzahl von Druckmessleitungen (213) angeordnet ist.

6. Fluidabgabevorrichtung nach Anspruch 5, ferner umfassend ein Fitting, das in einem vierten Anschluss (219) angeordnet ist, der in einer Seitenfläche (201 b) des einteiligen Verteilerkörpers (201) ausgebildet ist, wobei eine Spülleitung (221) das Fluidreservoir (216) fluidisch mit dem vierten Anschluss (219) koppelt und das Fitting dazu eingerichtet ist, die Spülleitung (221) fluidisch mit einer Entlüftungsleitung zu verbinden.

7. Fluidabgabevorrichtung nach Anspruch 1, wobei jede der Vielzahl von zweiten Fluidabgabeleitungen (211) einen Durchmesser zwischen etwa 0,5 mm und etwa 5 mm aufweist.

8. Fluidabgabevorrichtung nach Anspruch 1, wobei jedes der Vielzahl von Auslassfittings (205) dazu eingerichtet ist, die jeweilige zweite Fluidabgabeleitung (211) fluidisch mit der Abgabeleitung (126) zu koppeln, die einen größeren Durchmesser als die jeweilige zweite Fluidabgabeleitung (211) aufweist.

9. Fluidabgabevorrichtung nach Anspruch 8, ferner umfassend eine Vielzahl von Abgabeleitungen (126), die jeweils mit jeder der Vielzahl von zweiten Fluidabgabeleitungen (211) fluidisch gekoppelt sind.

10. Fluidabgabevorrichtung nach Anspruch 9, ferner umfassend eine Vielzahl von Ausgabedüsen (124), die jeweils mit jeder der Vielzahl von Abgabeleitungen (126) gekoppelt sind.

11. Fluidabgabevorrichtung nach Anspruch 1, wobei jede der Vielzahl von Druckmessleitungen (213) eine jeweilige zweite Fluidabgabeleitung (211) zwischen der ersten Fluidabgabeleitung (215) und einem jeweiligen Auslassanschluss (207) schneidet.

12. Fluidabgabevorrichtung nach Anspruch 11, wobei jede der Vielzahl von Druckmessleitungen (211) einen Durchmesser zwischen etwa 0,5 mm und etwa 5 mm aufweist.

13. Verfahren zum Erkennen einer Verstopfung oder Verengung in einem Mehrfach-Ausgabedüsen-Fluidabgabesystem, umfassend:
Leiten eines Polierfluids zu einem Einlassanschluss einer Fluidabgabevorrichtung nach einem oder mehreren der Ansprüche 1-11 und
einer Druckmessvorrichtung, die mit dem Druckmessanschluss fluidisch gekoppelt ist;
Messen, unter Verwendung der Druckmessvorrichtung, eines Drucks des in der Vielzahl von zweiten Fluidabgabeleitungen (211) angeordneten Polierfluids; und
Ausgeben des Polierfluids auf eine Oberfläche eines Polierkissens durch eine Vielzahl von Ausgabedüsen (124), wobei jede der Vielzahl von Ausgabedüsen (124) mit jeweiligen Abgabeleitungen (126) der Vielzahl von Abgabeleitungen (126) fluidisch gekoppelt ist.

14. Verfahren nach Anspruch 13, wobei der Verteilerkörper (201) fest an einem Poliersystem montiert ist und unterhalb einer horizontalen Ebene eines Abgabearms angeordnet ist, in dem die Vielzahl von Ausgabedüsen (124) angeordnet ist.

15. Verfahren nach Anspruch 13, ferner umfassend:
Überwachen, unter Verwendung einer Systemsteuerung, des gemessenen Drucks des in den zweiten Fluidabgabeleitungen (211) angeordneten Polierfluids;
Bestimmen einer Änderung des gemessenen Drucks; und
Initiieren einer Änderung in einem Polierprozess und/oder Warnen eines Benutzers basierend auf der bestimmten Änderung des gemessenen Drucks.

16. Verfahren nach Anspruch 15, wobei die Änderung des gemessenen Drucks einer Verstopfung in einer oder mehreren der Fluidabgabeleitungen, einer oder mehreren der Vielzahl von Ausgabedüsen (124) oder beiden entspricht.

## Revendications

1. Appareil de distribution de fluide pour la distribution de fluides pendant la planarisation mécano-chimique d'un substrat, comprenant :
• un corps de collecteur monobloc (201) comportant un orifice d'entrée (214), une pluralité d'orifices de sortie (207), un orifice de mesure de pression (210), un premier conduit de distribution de fluide (215), une pluralité de deuxièmes conduits de distribution de fluide (211), et une pluralité de conduits de mesure de pression (213) formés dans celui-ci ; et
• une pluralité de raccords de sortie (205) disposés respectivement dans chacun de la pluralité d'orifices de sortie (207), dans lequel chacun de la pluralité de raccords de sortie (205) forme respectivement un joint étanche face à face avec chacun de la pluralité d'orifices de sortie (207), et chacun de la pluralité de raccords de sortie (205) est configuré pour raccorder de manière fluide la pluralité de deuxièmes conduits de distribution de fluide (211) à une conduite de distribution (126) correspondante d'une pluralité de conduites de distribution ;
• l'orifice d'entrée (214) est en communication fluide avec la pluralité d'orifices de sortie (207) à travers le premier conduit de distribution de fluide (215) et la pluralité de deuxièmes conduits de distribution de fluide (211), la pluralité de deuxièmes conduits de distribution de fluide (211) raccordent le premier conduit de distribution de fluide (215) à la pluralité d'orifices de sortie (207), et
• la pluralité de conduits de mesure de pression (213) raccordent l'orifice de mesure de pression (210) à des conduits correspondants de la pluralité de deuxièmes conduits de distribution de fluide (211).

2. Appareil de distribution de fluide selon la revendication 1, comprenant d'environ 2 à environ 20 deuxièmes conduits de distribution de fluide (211).

3. Appareil de distribution de fluide selon la revendication 1, dans lequel le corps de collecteur monobloc (201) est formé d'un fluoropolymère.

4. Appareil de distribution de fluide selon la revendication 1, comprenant en outre un dispositif de mesure de pression (206) couplé de manière fluide à l'orifice de mesure de pression (210).

5. Appareil de distribution de fluide selon la revendication 4, dans lequel la pluralité de conduits de mesure de pression (213) sont en communication fluide directe avec un réservoir de fluide (216) disposé entre le dispositif de mesure de pression (206) et la pluralité de conduits de mesure de pression (213).

6. Appareil de distribution de fluide selon la revendication 5, comprenant en outre un raccord disposé dans un quatrième orifice (219) formé dans une surface latérale (201b) du corps de collecteur monobloc (201), dans lequel un conduit de purge (221) couple de manière fluide le réservoir de fluide (216) au quatrième orifice (219), et le raccord est configuré pour raccorder de manière fluide le conduit de purge (221) à une ligne de purge.

7. Appareil de distribution de fluide selon la revendication 1, dans lequel chacun de la pluralité de deuxièmes conduits de distribution de fluide (211) a un diamètre compris entre environ 0,5 mm et environ 5 mm.

8. Appareil de distribution de fluide selon la revendication 1, dans lequel chacun de la pluralité de raccords de sortie (205) est configuré pour coupler de manière fluide le deuxième conduit de distribution de fluide (211) respectif à la conduite de distribution (126) ayant un diamètre supérieur à celui du deuxième conduit de distribution de fluide (211) respectif.

9. Appareil de distribution de fluide selon la revendication 8, comprenant en outre une pluralité de conduites de distribution (126) couplées respectivement de manière fluide à chacun de la pluralité de deuxièmes conduits de distribution de fluide (211).

10. Appareil de distribution de fluide selon la revendication 9, comprenant en outre une pluralité de buses de distribution (124) couplées respectivement à chacune de la pluralité de conduites de distribution (126).

11. Appareil de distribution de fluide selon la revendication 1, dans lequel chacun de la pluralité de conduits de mesure de pression (213) croise un deuxième conduit de distribution de fluide (211) respectif entre le premier conduit de distribution de fluide (215) et un orifice de sortie (207) respectif.

12. Appareil de distribution de fluide selon la revendication 11, dans lequel chacun de la pluralité de conduits de mesure de pression (211) a un diamètre compris entre environ 0,5 mm et environ 5 mm.

13. Procédé de détection d'une obstruction ou d'une restriction dans un système de distribution de fluide à buses de distribution multiples, comprenant :
• l'écoulement d'un fluide de polissage vers un orifice d'entrée d'un appareil de distribution de fluide selon une ou plusieurs des revendications 1 à 11, et un dispositif de mesure de pression couplé de manière fluide à l'orifice de mesure de pression ;
• la mesure, au moyen du dispositif de mesure de pression, d'une pression du fluide de polissage disposé dans la pluralité de deuxièmes conduits de distribution de fluide (211) ; et
• la distribution du fluide de polissage sur une surface d'un tampon de polissage à travers une pluralité de buses de distribution (124), dans lequel chacune de la pluralité de buses de distribution (124) est couplée de manière fluide à des conduites de distribution (126) respectives de la pluralité de conduites de distribution (126).

14. Procédé selon la revendication 13, dans lequel le corps de collecteur (201) est monté de manière fixe sur un système de polissage et est disposé au-dessous d'un plan horizontal d'un bras de distribution dans lequel la pluralité de buses de distribution (124) est disposée.

15. Procédé selon la revendication 13, comprenant en outre :
• la surveillance, au moyen d'un organe de commande de système, de la pression mesurée du fluide de polissage disposé dans les deuxièmes conduits de distribution de fluide (211) ;
• la détermination d'un changement de la pression mesurée ; et
• le déclenchement d'un changement dans un processus de polissage et/ou l'alerte d'un utilisateur sur la base du changement déterminé de la pression mesurée.

16. Procédé selon la revendication 15, dans lequel le changement de la pression mesurée correspond à une obstruction dans une ou plusieurs des conduites de distribution de fluide, une ou plusieurs de la pluralité de buses de distribution (124), ou les deux.
